# EUROPEAN PATENT APPLICATION

(11) **EP 1 748 483 A2**
(43) Date of publication of application: **31.01.2007**
(21) Application number: 05025069.5
(22) Date of filing: 16.11.2005
(51) Int. Cl.: H01L 23/367

(54) **Heat dissipating device**

(30) Priority: 26.07.2005 CN 200510087051
(71) Applicant: Nanoforce Technologies Corporation, Tucheng City Taipei County, Taiwan, R.O.C. (TW)
(72) Inventor: Huang, Fu-Kuo, Tucheng City, Taipei County (TW)
(74) Representative: Kador & Partner

(57) **Abstract**

A dissipating device at least has a dissipating device component (10). The dissipating device component is woven by using a line-shaped heat dissipating body (12) or a plate-shaped heat dissipating body or formed by disposing the line-shaped heat dissipating body or the plate-shaped heat dissipating body around thereof. In this way, the dissipating device component (10) has a larger heat dissipating area compared and thus has the higher heat dissipation efficiency compared to that of prior art.

## Description

### BACKGROUND OF THE INVENTION

### 1. Field of the Invention

The present invention is related to a heat dissipating device, and more particularly to a heat dissipating device that improves the heat dissipating efficiency to dissipate heat from an electronic device more effectively.

### 2. Description of Related Art

Nowadays, various electronic products, such as a computer's central processing unit (CPU) or a motor, flood our daily lives. During operation, electronic products generate heat. With the progress of technologies and affection of current trends, electronic products become high-efficient, light, thin, and compact. However, heat generated therefrom is also increased and difficult to be dissipated. If the problem of heat dissipation is not resolved, the operation efficiency of electronic products will be degraded.

Taking a computer for an example, the present CPU must have a heat dissipating device, such as a device with heat dissipating fins, installed thereon. Heat generated from the CPU is transferred to the device with heat dissipating fins and dissipated thereby. An electric fan can be installed on the device with heat dissipating fins to speed up heat dissipation. However, since the operating frequency of present CPUs is higher and higher and the heat dissipating areas of heat dissipating devices are limited, the heat dissipation efficiency is not sufficient. For this reason, the CPUs are easy to operate abnormally. Sometimes, the CPUs may be overheated and thus destroyed. Moreover, devices with heat dissipating fins are difficult to be made. Their manufacturing process consumes a lot of time. Hence, the production efficiency is low.

In addition, since the operation of motors is also easy to generate a lot of heat, most of the present motors have devices with heat dissipating fins installed thereon to dissipate heat generated therefrom. As description above, if motors operate in a long period of time or in a high speed, due to the heat dissipation efficiency of the heat dissipating fins is not sufficient, the heat accumulated in the motors will increase unceasingly. As a result, the motors may operate abnormally or be destroyed. That is very dangerous.

Therefore, the present invention provides a heat dissipating device that has a larger heat dissipating area to dissipate heat generated from electronic device. Hence, the present invention can improve the heat dissipation efficiency and resolve the problem of prior art.

### SUMMARY OF THE INVENTION

An objective of the present invention is to provide a dissipating device that has a larger heat dissipating area than that of prior art. Hence, heat generated from electronic devices can be dissipated speedily. It means that heat can be transferred faster from electronic devices to the heat dissipating device of the present invention. In this way, the efficiency of dissipating heat generated from the electronic devices is enhanced.

Another objective of the present invention is to provide a dissipating device that has a simple structure and hence has a simple manufacturing process. Therefore, the cost is low and the production efficiency is high.

For achieving the objectives above, the present invention provides a dissipating device at least having a dissipating device component. The dissipating device component is woven by using the line-shaped heat dissipating body or the plate-shaped heat dissipating body or formed by disposing the line-shaped heat dissipating body or the plate-shaped heat dissipating body around thereof. The dissipating device component is woven via a knitting process or a woven process. In this way, the dissipating device component has a larger heat dissipating area compared to that of prior art and thus has a higher heat dissipation efficiency. The heat dissipating device is suitable to be installed on an electronic device that generates heat, such as a CPU or a motor. When the heat dissipating device is installed on the CPU, an addition electric fan can be installed thereon to dissipate heat generated from the CPU more speedily.

The above summaries are intended to illustrate exemplary embodiments of the invention, which will be best understood in conjunction with the detailed description to follow, and are not intended to limit the scope of the appended claims.

### BRIEF DESCRIPTION OF THE DRAWINGS

The features of the invention believed to be novel are set forth with particularity in the appended claims. The invention itself however may be best understood by reference to the following detailed description of the invention, which describes certain exemplary embodiments of the invention, taken in conjunction with the accompanying drawings, in which:
Fig. 1 is a schematic diagram of the present invention;
Fig. 2 is an exploded view of the present invention; and
Fig. 3 is an elevational view of another embodiment of the present invention.

### DETAILED DESCRIPTION OF PREFERRED EMBODIMENTS

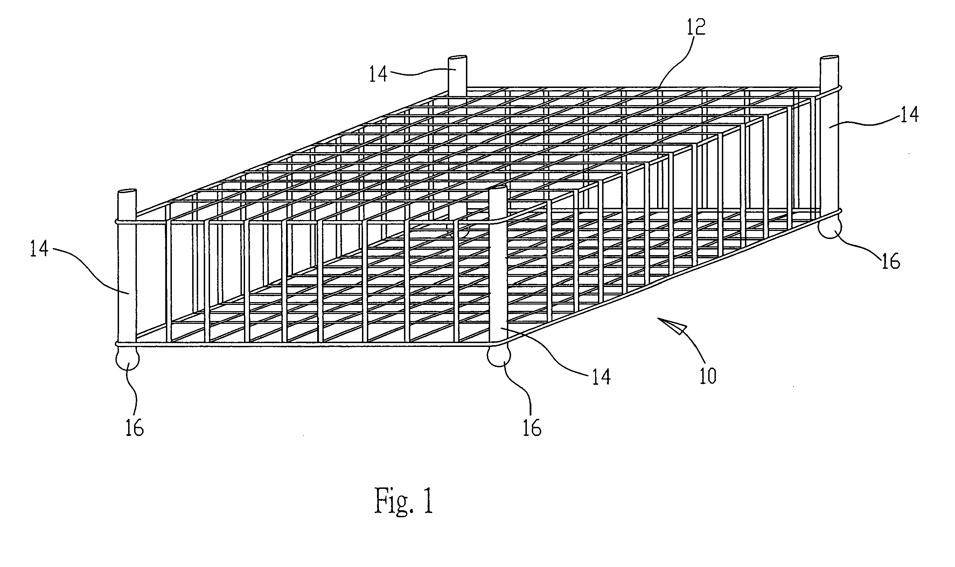

Re ference is made to Fig. 1, which is a schematic diagram of the present invention. As shown in the figure, the present invention includes a heat dissipating component 10 installed on an electronic device to dissipate heat generated therefrom. The heat dissipating component 10 includes at least a line-shaped heat dissipating body 12, which can be replaced by a plate-shaped heat dissipating body. The line-shaped heat dissipating body 12 or the plate-shaped heat dissipating body is made of metal. The heat dissipating component 10 is a heat dissipating fabric that is woven by using the line-shaped heat dissipating body 12 or the plate-shaped heat dissipating body. The line-shaped heat dissipating body 12 or the plate-shaped heat dissipating body at least forms at least a layer of heat dissipating network. In order to further improve the heat dissipating efficiency of the heat dissipating component 10, the line-shaped heat dissipating body 12 or the plate-shaped heat dissipating body can forms a plurality of layers of heat dissipating network. In this way, the heat dissipating component 10 has a 3-D heat dissipating structure and the heat dissipating area is thus increased.

In addition, the heat dissipating component 10 can also be formed by making the line-shaped heat dissipating body 12 or the plate-shaped heat dissipating body surround thereof. For example, the structure of the dissipating component 10 may be similar as that of a steel wire ball that is used for cleaning. In this way, the heat dissipating area of the heat dissipating component 10 can also be increased. According to the description above, since the heat dissipating area of the heat dissipating component 10 of the present invention is increased, the heat dissipating efficiency of the heat dissipating component 10 is increased effectively. Moreover, since the structure of the present invention is very simple, the present invention is easy to be accomplished. Thus, the cost is reduced and the production efficiency is increased.

In order to further improve the heat dissipating efficiency of the heat dissipating component 10, the heat dissipating component 10 of the present invention includes a plurality of fixing poles 14 for installation of an electric fan. In this way, heat generated from the electronic device and passed to the heat dissipating component 10 can be dissipated speedy. The fixing poles 14 can also be heat dissipating fixing poles. It means that the fixing poles 14 can be made of metal to increase the heat dissipating efficiency of the heat dissipating component 10. Each of the lower ends of the fixing poles 14 has a tin ball 16 for welding. The tin balls 16 are used to fixing the heat dissipating component 10. The tin balls 16 can also be provided between the line-shaped heat dissipating body 12 (or the plate-shaped heat dissipating body) and the heat dissipating component 10. The fixing poles 14 of the present invention can also be fixed on the electronic device without the tin balls 16. For example, the fixing poles 14 of the present invention can also be fixed by using the corresponding fixing holes of the electronic device. Furthermore, the fixing poles 14 can also used to support the electric fan.

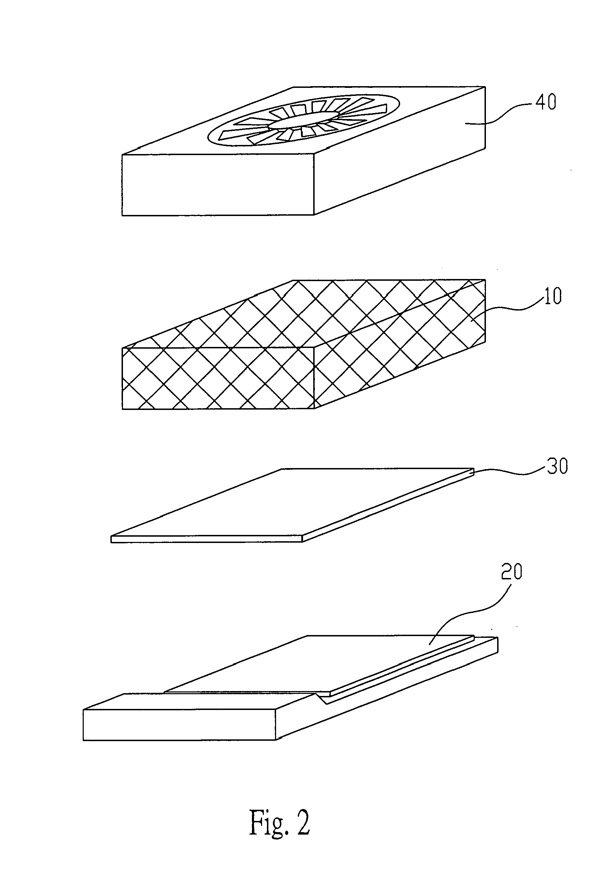

Reference is made to Fig. 1 together with Fig. 2, which is an exploded view of the present invention. As shown in the figure, when the present invention is installed on the CPU 20, i.e. the heat dissipating component 10 is installed on the CPU 20, in order to transfer heat generated from the CPU 20 more easily to the heat dissipating component 10, a heat transfer component 30 is combined with the heat dissipating component 10. The heat transfer component 30 can be made of a metal plate, such as a copper foil. When the installation of the heat dissipating component 10 on the CPU 20 is completed, the heat transfer component 30 is located between the CPU 20 and the heat dissipating component 10. Furthermore, in order to fix the heat transfer component 30 between the CPU 20 and the heat dissipating component 10, heat transfer glue is applied uniformly between the CPU 20 and the heat transfer component 30. In this way, the heat transfer component 30 is adhered on the CPU 20. Thereby, the heat transfer component 30 is fixed on the CPU 20. In the present invention, the heat dissipating component 10 is fixed on the heat transfer component 30 by using tin balls 16. However, in practice, the heat dissipating component 10 can also be fixed on the heat transfer component 30 by using heat transfer glue.

In addition, in order to speed up the dissipation of heat generated from the CPU 20, an electric fan 40 is installed on the heat dissipating component 10. In the present invention, the heat dissipating component 10 further has fixing poles 14 to support the electric fan 40. In this way, when the electric fan 40 is installed on the heat dissipating component 10, the electric fan 40 is not attached closely to the heat dissipating component 10 and a gap is provided between the electric fan 40 and the heat dissipating component 10. Thus, degradation of the heat dissipation efficiency of the heat dissipating component 10 caused by installation of the electric fan 40 is prevented.

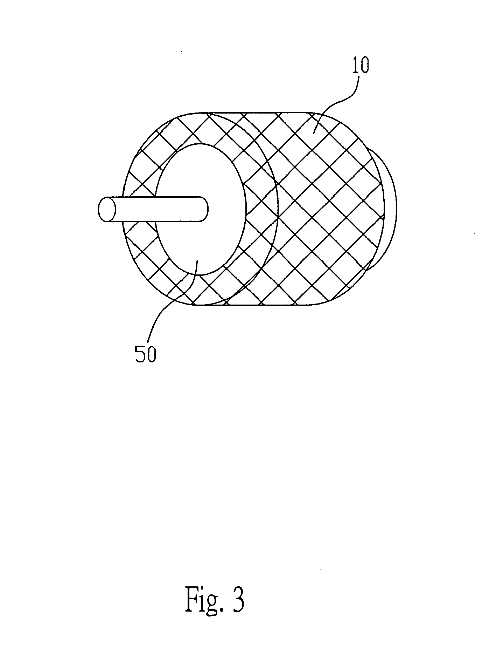

Reference is made to Fig. 3, which is an elevational view of another embodiment of the present invention. As shown in the figure, the heat dissipating component 10 of the present invention can be installed on a motor 50 to dissipate heat generated therefrom. The difference of this embodiment to the previous one is that the heat dissipating component 10 is tube-shaped and installed around the motor 50. The heat dissipating component 10 can also be plate-shaped and wrapped directly around the motor 50. In this way, the heat generated from the motor 50 can be transferred to the heat dissipating component 10 and dissipated thereby.

In accordance with the two embodiments mentioned above, the heat dissipating component 10 of the present invention is woven by using the line-shaped heat dissipating body or the plate-shaped heat dissipating body or formed by disposing the line-shaped heat dissipating body or the plate-shaped heat dissipating body around thereof. Hence, the present invention has a large heat dissipating area and a room for air circulation. Thereby, the heat dissipation efficiency is improved effectively. In addition, according to the shapes of electronic devices, the heat dissipating component 10 can be made with various shapes correspondingly. Hence, the present invention is suitable to be installed on any kind of electronic device no matter what shape it has. Accordingly, the heat dissipating component 10 can be used alone for heat dissipation. In addition, the heat dissipating component 10 can also be combined with an electric fan to improve the heat dissipation efficiency.

To sum up, the heat dissipating device of the present invention can be installed on an electronic device, such as a CPU or a motor, to dissipate heat generated therefrom. The heat dissipating device at least has a heat dissipating component. The heat dissipating component is woven by using the line-shaped heat dissipating body or the plate-shaped heat dissipating body or formed by disposing the line-shaped heat dissipating body or the plate-shaped heat dissipating body around thereof. Thus, the heat dissipating area is increased effectively and the heat dissipation efficiency is improved thereby. When the heat dissipating device is installed on a CPU, it can be combined with an electric fan to further enhance the heat dissipation efficiency.

Although the present invention has been described with reference to the preferred embodiments thereof, it will be understood that the invention is not limited to the details thereof. Various substitutions and modifications have been suggested in the foregoing description, and others will occur to those of ordinary skill in the art. Therefore, all such substitutions and modifications are embraced within the scope of the invention as defined in the appended claims.

## Claims

1. A heat dissipating device, installed on a central processing unit (CPU) to dissipate heat generated therefrom, the heat dissipating device comprising:
a heat dissipating component at least including a line-shaped heat dissipating body or the plate-shaped heat dissipating body; and
an electric fan installed on the heat dissipating component.

2. The heat dissipating device as claimed in claim 1, wherein the heat dissipating component is a heat dissipating fabric that is woven by using the line-shaped heat dissipating body or the plate-shaped heat dissipating body.

3. The heat dissipating device as claimed in claim 1, wherein the line-shaped heat dissipating body or the plate-shaped heat dissipating body is disposed to surround the heat dissipating component.

4. The heat dissipating device as claimed in claim 1, wherein the line-shaped heat dissipating body or the plate-shaped heat dissipating body is made of metal.

5. The heat dissipating device as claimed in claim 1, wherein the heat dissipating component has a heat transfer component disposed thereon, and the heat transfer component is placed on the CPU when the heat dissipating component is installed on the CPU.

6. The heat dissipating device as claimed in claim 5, wherein the heat transfer component and the CPU have a heat transfer glue applied therebetween and the heat transfer glue is used to fix the heat transfer component on the CPU.

7. The heat dissipating device as claimed in claim 1, wherein the heat dissipating component further has a plurality of fixing poles.

8. The heat dissipating device as claimed in claim 7, wherein the fixing poles are heat dissipating fixing poles.

9. A heat dissipating device, installed on a motor to dissipate heat generated therefrom, the heat dissipating device at least comprising a heat dissipating component, which at least includes a line-shaped heat dissipating body or a plate-shaped heat dissipating body.

10. The heat dissipating device as claimed in claim 9, wherein the heat dissipating component is a heat dissipating fabric that is woven by using the line-shaped heat dissipating body or the plate-shaped heat dissipating body.

11. The heat dissipating device as claimed in claim 9, wherein the line-shaped heat dissipating body or the plate-shaped heat dissipating body is disposed to surround the heat dissipating component.

12. The heat dissipating device as claimed in claim 9, wherein the line-shaped heat dissipating body or the plate-shaped heat dissipating body is made of metal.

13. The heat dissipating device as claimed in claim 9, wherein the heat dissipating component is tube-shaped and installed around the motor.

14. A heat dissipating device, installed on an electronic device to dissipate heat generated therefrom, the heat dissipating device at least comprising a heat dissipating component, which at least includes a line-shaped heat dissipating body or a plate-shaped heat dissipating body.

15. The heat dissipating device as claimed in claim 14, wherein the heat dissipating component is a heat dissipating fabric that is woven by using the line-shaped heat dissipating body or the plate-shaped heat dissipating body.

16. The heat dissipating device as claimed in claim 14, wherein the line-shaped heat dissipating body or the plate-shaped heat dissipating body is disposed to surround the heat dissipating component.

17. The heat dissipating device as claimed in claim 14, wherein the line-shaped heat dissipating body or the plate-shaped heat dissipating body is made of metal.
